# EUROPEAN PATENT SPECIFICATION

(11) **EP 0 528 540 B1**
(45) Date of publication and mention of the grant of the patent: **30.08.1995**
(21) Application number: 92306545.2
(22) Date of filing: 16.07.1992
(51) Int. Cl.: C23C 16/30, C23C 16/50

(54) **Thin-film coatings made by means of plasma-activated chemical vapor deposition of fluorinated cyclic siloxanes**
Dünne Filmbeschichtungen, hergestellt unter Verwendung von plasmaaktivierter chemischer Dampfphasen-Abscheidung von fluorierten Cyclosiloxanen
Revêtements en film mince obtenus par déposition chimique en phase gazeuse activée par plasma des siloxanes cycliques fluorés

(30) Priority: 22.07.1991 IT MI912018
(43) Date of publication of application: 24.02.1993
(73) Proprietor: DOW CORNING CORPORATION, Midland Michigan 48686-0994 (US)
(72) Inventor: d'Agostino, Riccardo, I-70121 Bari (IT); Caporiccio, Gerardo, I-20149 Milano (IT); Favia, Pietro, I-70123 Bari (IT)
(74) Representative: Dowden, Marina

(56) References cited:
- CHEMICAL ABSTRACTS, vol. 110, no. 8, 20 February 1989, Columbus, Ohio, US; abstract no. 59602r, page 108, column R; & JP-A-63 165 461
- CHEMICAL ABSTRACTS, vol. 111, no. 26, 25 December 1989, Columbus, Ohio, US; abstract no. 238365h, page 333, column R; & JP-A-01 124 805
- CHEMICAL ABSTRACTS, vol. 101, no. 26, 24 December 1984, Columbus, Ohio, US; abstract no. 238186u, page 485, column L; & JP-A-59 105 637

## Description

The present invention refers to coatings produced by means of the deposition of thin films formed by plasma-activated chemical vapor deposition of volatile fluorinated cyclic siloxanes having the structure [RR′SiO]ₓ, where R is an alkyl group with 1-6 carbon atoms, R′ is a fluorinated alkyl group with 3-10 carbon atoms, the carbon in the alpha and beta positions with respect to the silicon atom is hydrogenated and x is 3 or 4. These particular coatings are useful because of their properties of protection and insulation.

The present invention refers to coatings produced by means of the deposition of thin films formed by plasma-activated chemical vapor deposition of volatile fluorinated cyclic siloxanes having the structure [RR′SiO]ₓ, where R is an alkyl group with 1-6 carbon atoms, R′ is a fluorinated alkyl group with 3-10 carbon atoms, the carbon in the alpha and beta positions with respect to the silicon atom is hydrogenated and x is 3 or 4. The process consists of introducing vaporized siloxane into a deposition chamber containing the substrate to be coated; the reaction of the vapor is then induced by means of a plasma that has been excited by radio-frequency (RF) [electric field]. The particular coatings thus produced have useful physical properties.

Plasma-activated chemical vapor deposition of thin films using gases or chemical vapors is a well-known technique in the field of film formation or coating various substrates. Numerous chemical vapors useful in this technique, which allow the formation of various films, are known. For example, thin films containing silicon and carbon can be obtained by means of plasma-activated chemical vapor deposition from mixtures of silane (SiH₄)-methane or silane-ethylene, as well as from mixtures of tetramethylsilaneargon. Similarly, the production of silicon oxide-type films from silanes (for example, SiH₄, H₂SiCl₂, etc.) mixed with an oxidizing gas (for example, air, oxygen, ozone, NO₂, etc.) is known.

What was not yet known, however, is that volatile fluorinated cyclic siloxanes could be used as gaseous sources for plasma-activated chemical vapor deposition to obtain fluoropolymer films containing silicon.

The present invention refers to a method for the formation of a coating over a substrate. The method consists of introducing a sufficient quantity of vapor comprised of fluorinated cyclic siloxane with the structure [RR′SiO]ₓ in a deposition chamber containing the substrate, in which R is a hydrocarbon radical with 1-6 carbon atoms, R′ is a fluorinated hydrocarbon radical with 3-10 carbon atoms, the carbon in the alpha and beta positions with respect to the silicon atom is hydrogenated and x is 3 or 4. The decomposition reaction of the vapor in the chamber is then induced by the effect of the discharge of the plasma excited by radio frequencies (RF) in the chamber.

The present invention also refers to the particular coatings produced with the preceding method.

The present invention is based on the discovery that particular coatings can be formed from vapors of fluorinated cyclic siloxane. The coatings are formed over the substrates when a discharge of a plasma excited by radio frequencies induces the reaction of the siloxane vapor which, in turn, forms the polymer film deposit on the surface of the substrate. The chemical vapors or the source gases that are used in the present method consist of fluorinated cyclic siloxanes. More specifically, the source gases are fluorinated cyclic siloxanes having the structure [RR′SiO]ₓ. where R is a hydrocarbon radical with 1-6 carbon atoms, R′ is a fluorinated hydrocarbon radical with 3-10 carbon atoms, the carbon in the alpha and beta positions with respect to the silicon atom is hydrogenated and x is 3 or 4. Examples of these materials include 2,4,6-tri(3,3,3-trifluoropropyl)-2,4,6-trimethylcyclotrisiloxane and 2,4,6-tri(3,3,4,4,5,6,6,6 nonafluorohexyl)2,4,6-trimethylcyclotrisiloxane. The preferred siloxane for use in this invention is 2,4,6-tri(3,3,3-trifluoropropyl)2,4,6-trimethylcyclotrisiloxane. These siloxanes and the methods for their production are well-known techniques in the field and many siloxanes are available on the market.

The siloxanes mentioned are used as vapors in the process of the present invention. These vapors are generally obtained by heating the siloxane to a temperature usually between about 50 and 200°C. The vapors thus obtained are then in general diluted with other gases such as inert transport gases (for example, argon, helium, etc.) or other gases that can modify the composition of the thin film. As an alternative, a transport gas like argon or helium can be saturated with the vapor of the liquid siloxane heated to a temperature of about 50 to 200°C.

The total pressure of the gas introduced into the deposition chamber should be controlled at a level that will facilitate discharge of the plasma and provide a reasonable rate of deposition of the coating. The pressures can be varied within a broad range, depending on the specific frequency used in the plasma. Generally, a total pressure of 1.33 to about 1333 Pa (0.01 to about 10 torr) provide conditions favorable to the process of deposition. Total pressures of 6.67 to about 133.3 Pa is preferred; a total pressure of about 13.3 Pa is preferred over the others.

The quantity of chemical vapor introduced into the chamber containing the plasma discharge should be sufficient to provide a partial pressure suited to the vacuum condition described above. Consequently, the quantity of vapors introduced should be regulated to provide a total pressure in the chamber ranging from 1.33 to 1333 Pa; pressures from 6.67 to 133.3 Pa are preferred. The process can be conducted under static conditions, but usually continuous introduction of a controlled quantity of vapor into one part of the chamber is preferred, creating a vacuum in another part of the chamber to as to cause a flow of vapor through the plasma-discharge area. A sufficient quantity of vapor to provide a vapor pressure of about 1.33 to 1333 Pa in the chamber is introduced continuously, whereas support gases, gaseous products, or other modified gasses are continually extracted from the chamber at a corresponding rate.

The vapor introduced into the chamber is then submitted to a plasma discharge by RF. This discharge is generally produced by means of an AC generator that provides a radio frequency between about 1 and 100 MHz, with a power at the exit between 1 and 1000 W. Particularly preferred are the plasma conditions obtained [with] a radio frequency between about 13.56 and 27 MHz and a power between about 20 and 200 W.

The temperature of the substrate inside the chamber is generally controlled to facilitate the deposition of the film. Generally, temperatures ranging from room temperature up to about 300°C. are used.

The deposition chamber can also be modified without affecting the present invention. For example, the siloxane vapors can be exposed to the plasma discharge in a position far from the substrate and the reaction products can subsequently be directed onto the substrate. Analogously, the geometry of the discharge can be a configuration with a diode or triode reactor and/or the substrate can be maintained at a negative polarization induced by RF (understood as "bias voltage") applied during deposition. Such negative polarization ("Bias voltage") can vary between 0 and -100 V (minus 100 V).

The character and properties of the coatings deposited by means of the method of the present invention can vary within a wide range. For example, the coatings can be modified by changing conditions such as the temperature of the substrate, the voltage of the negative polarization applied to the substrate, the applied power, the feed gas, the geometry of the discharge, etc. The attached examples present a number of these deposition conditions.

The resulting coatings can be produced in many thicknesses, ranging from about 0.02 up to 2 micrometers.

Films or coatings obtained according to the invention include carbon, silicon, oxygen, hydrogen, and fluorine, at the following approximate atomic percentage (determined with X-ray photoelectron spectrography (XPS)):

| | |
|---|---|
| Carbon: | 30-60% |
| Silicon: | 10-25% |
| Oxygen: | 10-35% |
| Fluorine: | 10-36.5% |

Furthermore, hydrogen is also present in the coatings (as confirmed by the C-H signals in the infrared spectral analysis (FTIR type)) but cannot be quantified using XPS. Particularly noteworthy is the fact that the infrared spectral analysis (FTIR) does not indicate Si-F or Si-H signals as present in the coating.

These coatings have many desirable characteristics, such as high hardness, very low porosity, good adhesion to the substrates, high index of refraction, hydrophobicity, good characteristics of insulation, transparency and a lack of coloration. For example, the hardness of these coatings deposited on a glass substrate, as measured by ASTM D3633 pencil test, was 2B-9H; the hardness of those deposited on a silicon wafer was 2H-4H (the films classified in the H range are highly scratch-resistant). Similarly, the hydrophobicity, as measured by the angle of contact of a sessile drop of water deposited onto a substrate of glass coated with the film, was between 75° and 95°. The film also has good dielectrical properties, with a specific electrical conductivity between about 0.7 x 10⁻⁹ and about 17 x 10⁻⁹ ohm⁻¹·cm⁻¹ when deposited onto a glass substrate. Finally, the index of refraction of the coatings, measured in the visible region over a glass substrate, was between about 1.80 and 2.0.

When these characteristics are present simultaneously in the coatings of the present invention, they are useful for coating various types of substrates such as silicon wafers, glasses, ceramics, metals, and polymeric materials. For example, the presence of transparency and high hardness allows the films to be used as scratch-resistant coatings over a large number of plastic materials such as polycarbonate, polymethyl methacrylate, polyethylene, polypropylene, polyethylene terephthalate, and on some of their alloys and mixtures when they are molded or extruded in sheets, laminates, or plates used as glasses or screens of an organic polymer. Analogously, when the coatings are hydrophobic, transparent and colorless, they are useful in improving the sealing characteristics of materials for the packaging of food and pharmaceutical products. When the coatings are hydrophobic, transparent, colorless and have a high index of refraction and high hardness, they are useful for insulating glasses such as building facades, for example. When the coatings are transparent, colorless and have a high index of refraction and high hardness, they are useful as antiscratch coatings for ophthalmic lenses made of plastic or with soft mineral glasses with a high index of refraction. Finally, the combination of good characteristics of electrical insulation, hydrophobicity and high adhesion makes the coatings useful as an insulating, protective layer for microelectronics.

The following nonlimiting examples are provided so that an expert in the field may easily understand the invention.

### Example 1

A substrate of polished glass was placed on top of the grounded electrode of a diode-shaped plasma reactor and was connected to a radio-frequency generator of 13.56 MHz. 2,4,6-tri(3,3,3-trifluoropropyl)-2,4,6-trimethylcyclotrisiloxane was heated to 50°C. and introduced into the reactor, transported by a flow of argon at a rate of 6 standard cc/min. The temperature of the substrate was maintained at 30°C. and the pressure in the reactor was maintained at 13.33 Pa. The discharge of the plasma was started at 50 W and the thickness of the film was continuously monitored using laser interferometry. After 15 min the electrical supply was interrupted.

The coating, 1 »m thick, had the following characteristics:
--the angle of contact of a sessile water drop deposited onto the film was 91°;
--the hardness, measured with the ASTM D3363 "pencil test," corresponded to classification 2B;
--the electrical conductivity was 1.7 x 10⁻⁹ ohm⁻¹·cm⁻¹; and
--the index of refraction, determined by the Manifacier-Gaslot method, was 1.95 at 630 nm (25°C.) (see J. Physics, E: Scientific Instruments, 9, 1002, 1976).

### Example 2

A substrate of polished glass was placed in the same plasma reactor with the same conditions as in Example 1, except that the reactor was assembled with a triode configuration. The substrate was placed on the third electrode, connected to the radio frequency source and maintained at 30°C., with application of a polarization voltage of -50 V. After 16 min the electrical feeding was interrupted.

The resulting coating, 1.6 »m thick, had the following characteristics:
--the hardness, measured with the ASTM D3363 "pencil test," corresponded to pencil classification 6H;
--the electrical conductivity was 4 x 10⁻⁹ ohm⁻¹·cm⁻¹; and
--the index of refraction, determined by the Manifacier-Gaslot method, was 1.93 at 630 nm (25°C.).

### Example 3

A section of a silicon wafer was placed in the same plasma reactor under the same conditions as in Example 2, except that a "bias voltage" of -40 V was applied to the substrate maintained at 30°C. After 10 min the [power] supply was interrupted.

The resulting coating, 1.1 »m thick, had the following characteristics:
--the hardness, measured with the ASTM D3363 "pencil test," corresponded to pencil classification 4H;
--the angle of contact of a sessile water drop deposited onto the film was 89°;
--the X-ray photoelectron spectroscopy (XPS) analysis of the coating indicated the following atomic percentages of elements:

| | |
|---|---|
| Carbon | 31% |
| Oxygen | 22% |
| Fluorine | 31% |
| Silicon | 16% |

Furthermore, the XPS showed a reticulated structure. The FTIR analysis of the coating showed a 3000-cm⁻¹ band, indicative of the C-H group, a band from 1000 to 1150 cm⁻¹, indicative of O-Si-0, a 1210 cm⁻¹ band, indicative of the C-F group, and the absence of bands from 2100 to 2150 cm⁻¹, indicative of the Si-H groups. The spectral analysis did not show the presence of any Si-F groups.

### Example 4

A substrate of polished glass was placed in the same plasma reactor under the same conditions as in Example 21 [sic; 2], except that the temperature of the substrate was maintained at 200°C. and the "bias voltage" was -50 V. After 15 min the electrical supply was interrupted.

The resulting coating, 1.0 »m thick, had the following characteristics:
--the hardness, measured with ASTM D3363 "pencil test," corresponded to pencil classification 9H;
--the index of refraction, determined by the Manifacier-Gaslot method, was 1.91 at 630 nm (25°C.);
--the angle of contact of a sessile water drop deposited onto the film was 77°.

### Example 5

A section of a silicon wafer was placed in the same plasma reactor under the same conditions as in Example 2, except that a "bias voltage" of -60 V was applied to the substrate maintained at 30°C. After 10 min the electrical supply was interrupted.

The resulting coating, 1.5 »m thick, has the following characteristics:
--the hardness, measured with ASTM D3363 "pencil test," corresponded to pencil classification 4H;
--the angle of contact of a sessile water drop deposited onto the film was 82°;
--the X-ray photoelectron spectroscopy (XPS) analysis of the coating indicated the following atomic percentages of elements:

| | |
|---|---|
| Carbon | 42% |
| Oxygen | 18% |
| Fluorine | 25% |
| Silicon | 15% |

The FTIR analysis of the coating showed a 3000 cm⁻¹ band, indicative of the C-H group, a band from 1000 to 1150 cm⁻¹, indicative of O-Si-O, a 1210 cm⁻¹ band, indicative of the C-F group, and the absence of bands from 2100 to 2150 cm⁻¹, indicative of the Si-H groups.

### Example 6

A substrate of polished glass was placed in the same plasma reactor under the sane conditions as in Example 2, except that the temperature of the substrate was maintained at 80°C. and the "bias voltage" was -100 V. After 9 min the supply was interrupted.

The resulting coating, 0.76 »m thick, has the following characteristics:
--the hardness, measured with the ASTM D3363 "pencil test," corresponded to pencil classification 5H;
--the angle of contact of a sessile water drop deposited onto the film was 88°; and
--the electrical conductivity was 4 x 10⁻⁹ ohm⁻¹·cm⁻¹.

## Claims

1. A method for the formation of a coating over a substrate consisting of:
the introduction of a sufficient quantity of vapor into a deposition chamber containing the substrate; the vapor is comprised of a fluorinated cyclic siloxane with the structure [RR'SiO]ₓ, in which R is a hydrocarbon radical with 1-6 carbon atoms, R' is a fluorinated hydrocarbon radical with 3-10 carbon atoms, the carbon in the alpha and beta positions with respect to the silicon atom is hydrogenated and x is 3 or 4; and
induction of the reaction of the vapor in the chamber by the effect of a plasma discharge by radio frequency to cause the deposition of said coating on the substrate.

2. A method according to claim 1, in which the frequency of the plasma discharge is within a range of about 1 to 100 MHz.

3. A method according to claim 2, in which the frequency of the plasma discharge is between about 13.56 and 27 MHz.

4. A method according to any of claims 1 to 3, in which the temperature of the substrate is within a range of from room temperature to 300°C.

5. A method according to any of claims 1 to 4, in which the vapor is 2,4,6-tri(3,3,3-trifluoropropyl)-2,4,6-trimethylcyclotrisiloxane.

6. A method according to claim 5, in which the 2,4,6-tri(3,3,3-trifluoropropyl)-2,4,6-trimethylcyclotrisiloxane is diluted in an inert transport gas.

7. A method according to any of claims 1 to 6, in which the pressure in the deposition chamber is from 1.33 to about 1333Pa.

8. A method according to any of claims 1 to 7, in which the substrate is selected from a group consisting of silicon wafers, microelectronic devices, glasses, ceramic materials, metals, and polymeric materials.

9. Method of claim 8, in which the polymeric materials are selected from a group consisting of polycarbonate, polymethyl methacrylate, polyethylene, polypropylene and polyethylene terephthalate.

10. A substrate coated according to the method of any of the preceding claims.

## Patentansprüche

1. Verfahren zur Erzeugung einer Beschichtung auf einem Substrat, das darin besteht, daß man
eine genügende Menge Dampf in eine Abscheidekammer einführt, die das Substrat enthält; wobei der Dampf ein fluoriertes cyclisches Siloxan mit der Struktur [RR'SiO]ₓ enthält, in der R einen Kohlenwasserstoffrest mit 1 bis 6 Kohlenstoffatomen bedeutet, R' einen fluorierten Kohlenwasserstoffrest mit 3 bis 10 Kohlenstoffatomen bezeichnet, dessen Kohlenstoffatome in alpha- und beta-Stellung in bezug auf das Siliciumatom Wasserstoffatome tragen, und x für 3 oder 4 steht; und
die Reaktion des Dampfes in der Kammer durch die Wirkung einer Plasmaentladung durch Radiofrequenz induziert, um die Abscheidung der Beschichtung auf dem Substrat zu bewirken.

2. Verfahren nach Anspruch 1, wobei die Frequenz der Plasmaentladung in einem Bereich von etwa 1 bis 100 MHz liegt.

3. Verfahren nach Anspruch 2, wobei die Frequenz der Plasmaentladung zwischen etwa 13,56 und 27 MHz liegt.

4. Verfahren nach jedem der Ansprüche 1 bis 3, wobei die Temperatur des Substrats in einem Bereich von Raumtemperatur bis 300°C liegt.

5. Verfahren nach jedem der Ansprüche 1 bis 4, wobei der Dampf 2,4,6-Tri(3,3,3-trifluorpropyl)-2,4,6-trimethylcyclotrisiloxan ist.

6. Verfahren nach Anspruch 5, wobei das 2,4,6-Tri(3,3,3-trifluorpropyl)-2,4,6-trimethylcyclotrisiloxan mit einem inerten Transportgas verdünnt ist.

7. Verfahren nach jedem der Ansprüche 1 bis 6, wobei der Druck in der Abscheidekammer von 1,33 bis etwa 1.333 kPa beträgt.

8. Verfahren nach jedem der Ansprüche 1 bis 7, wobei das Substrat ausgewählt ist aus einer Gruppe, bestehend aus Siliciumwafern, mikroelektronischen Vorrichtungen, Gläsern, keramischen Materialien, Metallen und polymeren Materialien.

9. Verfahren nach Anspruch 8, wobei die polymeren Materialien ausgewählt sind aus einer Gruppe, bestehend aus Polycarbonat, Polymethylmethacrylat, Polyethylen, Polypropylen und Polyethylenterephthalat.

10. Substrat, beschichtet nach dem Verfahren eines jeden der vorhergehenden Ansprüche.

## Revendications

1. Procédé pour la formation d'un revêtement sur un substrat, consistant en :
l'introduction d'une quantité suffisante de vapeur dans une chambre de dépôt contenant le substrat ; la vapeur est constituée d'un siloxane cyclique fluoré ayant la structure [RR'SiO]ₓ, où R est un radical hydrocarboné ayant 1 à 6 atomes de carbone, R' est un radical hydrocarboné fluoré ayant 3 à 10 atomes de carbone, le carbone aux positions alpha et bêta par rapport à l'atome de silicium est hydrogéné et x est 3 ou 4 ; et
le déclenchement de la réaction de la vapeur dans la chambre par l'effet d'une décharge de plasma par radiofréquence pour provoquer le dépôt dudit revêtement sur le substrat.

2. Procédé selon la revendication 1, dans lequel la fréquence de décharge du plasma est dans la gamme d'environ 1 à 100 MHz.

3. Procédé selon la revendication 2, dans lequel la fréquence de la décharge de plasma est entre environ 13,56 et 27 MHz.

4. Procédé selon l'une quelconque des revendications 1 à 3, dans lequel la température du substrat est dans la gamme de la température ambiante à 300 °C.

5. Procédé selon l'une quelconque des revendications 1 à 4, dans lequel la vapeur est un 2,4,6-tri(3,3,3-trifluoropropyl)-2,4,6-triméthylcyclotrisiloxane.

6. Procédé selon la revendication 5, dans lequel le 2,4,6-tri(3,3,3-trifluoropropyl)-2,4,6-triméthylcyclotrisiloxane est dilué dans un gaz de transport inerte.

7. Procédé selon l'une quelconque des revendications 1 à 6, dans lequel la pression dans la chambre de dépôt est de 1,33 à environ 1333 Pa.

8. Procédé selon l'une quelconque des revendications 1 à 7, dans lequel le substrat est choisi dans le groupe constitué des tranches de silicium, des dispositifs microélectroniques, des verres, des matières céramiques, des métaux et des matières polymères.

9. Procédé selon la revendication 8, dans lequel les matières polymères sont choisies dans le groupe constitué d'un polycarbonate, d'un polyméthacrylate de méthyle, d'un polyéthylène, d'un polypropylène et d'un polytéréphtalate d'éthylène.

10. Substrat revêtu selon le procédé de l'une quelconque des revendications précédentes.
